# EUROPEAN PATENT SPECIFICATION

(11) **EP 0 364 929 B1**
(45) Date of publication and mention of the grant of the patent: **06.09.1995**
(21) Application number: 89119187.6
(22) Date of filing: 16.10.1989
(51) Int. Cl.: H01J 37/317, H01J 37/09, G03F 7/20

(54) **Fabrication method of semiconductor devices and transparent mask for charged particle beam**
Herstellungsverfahren für Halbleitervorrichtungen und durchsichtige Maske für den geladenen Teilchenstrahl
Méthode de fabrication de dispositifs semiconducteurs et masque transparent au faisceau de particules chargées

(30) Priority: 20.10.1988 JP 264617/88; 24.10.1988 JP 267522/88
(43) Date of publication of application: 25.04.1990
(73) Proprietor: FUJITSU LIMITED, Kawasaki-shi, Kanagawa 211 (JP)
(72) Inventor: Kataoka, Toyotaka, Hamamatsu-shi Shizuoka, 432 (JP); Sakamoto, Kiichi, Toshima-ku Tokyo, 170 (JP)
(74) Representative: Schmidt-Evers, Jürgen, Dipl.-Ing.

(56) References cited:
- US-A- 4 213 053
- PATENT ABSTRACTS OF JAPAN, vol. 12, no. 135 (E-604)(2982) 23 April 1988 & JP-A-62 260 322
- PATENT ABSTRACTS OF JAPAN, vol. 7, no. 288 (E-218)(1433) 22 December 1983 & JP-A-58 165 325
- IEEE TRANSACTIONS ON ELECTRON DEVICES. vol. ED-26, no. 4, 1979, NEW YORK US, pages 663-674; H. C. Pfeiffer: "Recent advances in electron-beam lithography for high-volume production of VLSI devices"

## Description

### FIELD OF THE INVENTION

The present invention relates to fabrication of semiconductor devices that employs a charged particle beam exposure, such as an electron beam exposure or the like, and to a transparent mask for a charged particle beam.

The invention relates in particular to fabrication of semiconductor devices that employs a charged particle beam exposure of the formation beam type which uses a mask for transferring mask patterns, and to a transparent mask that is used in the charged particle beam exposure of the formation beam type.

In recent years, as the number of components on an Ic (integrated circuit) chip is increased, a charged particle beam exposure such as an electron beam exposure is rapidly replacing a lithographic exposure which has been normally used in the formation of circuit patterns of ICs for many years.

The charged particle beam exposure forms circuit patterns with the aid of an electron beam and the like capable of electromagnetic control, and has its advantage in that it can form submicron circuit patterns. The charged particle beam exposure is roughly classified into a Gaussian type beam method and a formation beam method.

It is noted that, in the present specification, "electromagnetic" is intended to mean "electric or magnetic", while "electromagnetic control" is intended to mean "electric field control and/or magnetic field control".

### DESCRIPTION OF THE PRIOR ART

Recently, there is a rapidly growing tendency that patterns of semiconductor devices become finer and finer. Exposure by an electron beam is capable of exposing submicron patterns and sufficiently meeting the requirements of resolution. However, the exposure by a fine spot scan or a subsequent shot exposure of a small variable rectangular beam has its disadvantage in that the throughput cannot be enhanced because of a so-called exposure with one stroke. Typically, to expose a larger area requires longer exposure time.

In order to overcome the lower throughput problem associated with the prior art, there is a block-pattern exposure method described in Japanese patent laid-open publication No. 52-119815. This block-pattern exposure method is one wherein a mask with different patterns formed on different block locations thereof is provided in the path of an electron beam, a requested block on the mask is selected by deflecting the electron beam, and the pattern of the selected block is exposed. If various circuit patterns are exposed by this method for a short period of time, it is then required to form a vast number of patterns on the mask. However, it is not practical that a mask with a vast number of such pattern blocks is manufactured and the electron beam exposure is performed.

Although there are other methods based on the same concept as the aforementioned Japanese patent laid-open publication No. 52-119815, all of them were difficult to use.

Japanese patent laid-open publication No. 62-260322 has proposed a beam shaping plate on which patterns numbering integer times the minimum unit of repeatedly formed patterns are formed along with at least one aperture in the form of square. By this square aperture, the beam shaping plate makes it possible to illuminate memory cell patterns as many as possible at a time, while maintaining generality of a variable rectangular beam exposure. However, the method using the beam shaping plate is also not practical because it requires one beam shaping plate for each repeated pattern. Furthermore, in order to effectively reduce the number of exposures with the method described in the aforesaid Japanese patent laid-open publication No. 62-260322, it is necessary that the area of a small partition which is the repeat unit described above is increased to the extent possible to contain transparent openings as many as possible and that patterns as many as possible can be formed by a single exposure. However, if the area of the small partition is increased and the charged beam is correspondingly widened, the charge density of the charged beam is reduced and consequently a single exposure time must be increased. Therefore, the aforementioned method undergoes a limitation in enhancement of throughput. For this reason, there has been proposed a method wherein a plurality of small partitions of small area are formed on a transparent mask, and one of the small partitions is selected when necessary, and exposed. However, since the area of the transparent mask itself is increased as the number of the small partitions increases and since a requested small partition is selected, when necessary, from the large number of the small partitions and operations such as mechanical movement of mask and deflection of charged beam are repeated, the large amount of time is needed and consequently a problem still remains in enhancing throughput.

It is, accordingly, an object of the present invention to provide an improved method of fabricating semiconductor devices which is suited for effectively printing repeated patterns with the aid of a charged particle beam.

Another object is to provide an improved transparent mask for a charged particle beam which is suitable for fabrication of semiconductor devices having repeated patterns.

Still another object is to provide an improved charged-beam exposure apparatus which is capable of reducing time required to select a requested small partition from among a plurality of small partitions on a transparent mask, as compared with the prior art, and which is thus capable of enhancing its throughput.

### SUMMARY OF THE INVENTION

In accordance with one important aspect of the present invention, the method for fabricating a semiconductor device comprises the steps of generating a charged particle beam, deflecting the charged particle beam electromagnetically and illuminating one small partition of a plurality of small transparent partitions that constitute one aggregate partition of a plurality of aggregate partitions formed on a transparent mask, reducing the charged particle beam patterned through the mask and exposing the same on a semiconductor device to be exposed, moving one aggregate partition of the plurality of aggregate partitions into a predetermined position by moving the transparent mask mechanically, and selecting one small partition from among the plurality of small transparent partitions of the moved aggregate partition.

In accordance with a further important aspect of the present invention, there is provided a transparent mask for a charged particle beam, the mask having patterns for patterning the charged particle beam and comprising a plurality of aggregate partitions, each aggregate partition having a small partition group with the small transparent partitions including transparent openings corresponding to components of circuit patterns of an integrated circuit, wherein the small partition group of one aggregate partition contains a first set of small partitions, each of which is an aperture pattern that is an independent pattern and used for an non-repeated pattern repeatedly used for exposure, and a second set of small partitions, each of which is a repeated basic pattern representing at least a portion of a figure that is a repeat unit for printing a repeated pattern on a semiconductor chip.

According to another aspect of the present invention, on the above transparent mask neighbouring aggregate partitions are isolted from one another by an isolated region, the size of each of the plurality of aggregate partitions is selected to a size such that the charged particle beam can be deflected with a charged particle beam exposure apparatus, and the size of each small partition is selected to a size such that the charged particle beam can be illuminated on the small partition at a time.

By patterning a relatively complicated figure, the number of exposure shots can be greatly reduced. If all of patterns are patterned, then the number becomes vast. If the vast number of patterns are formed on one transparent mask for a reduction exposure apparatus, the size of the transparent mask becomes larger and larger and easily exceeds a range in which a charged particle beam can be deflected electromagnetically. A time needed for electromagnetic deflection is of the order of microseconds, while several tens to several hundreds of milliseconds are needed to mechanically move the transparent mask 3. Consequently, the exposure time becomes longer.

The repeated patterns can be effectively exposed at a short time by dividing the transparent mask into a plurality of partitions, forming one partition to a size such that the charged particle beam can be deflected electromagnetically, forming repeated basic patterns, which are convenient to print a figure including one repeated pattern, on one partition along with an aperture pattern for non-repeated pattern, and preparing repeated patterns of each partition in correspondence with different figures.

A large number of figures can be effectively exposed with the aid of one transparent mask by providing a plurality of partitions on the transparent mask, positioning a requested one partition into a deflection range of the charged particle beam, and thereafter scanning the charged particle beam with the electromagnetic deflection.

When a new pattern is exposed, the transparent mask 3 is moved by the mechanical drive means 9a and 9b, and an adequate partition 4 is selected.

Since relatively larger patterns on the transparent mask 3 are reduced, it becomes easier to produce a latent image of a desired resolution.

In accordance with a further aspect of the present invention, a charged beam exposure apparatus is provided, comprising the foregoing transparent mask and means for generating a charged particle beam, deflection means for deflecting the charged particle beam electromagnetically and illuminating one small partition of the plurality of small partitions, mask movement means for moving the transparent mask mechanically, and reduction-exposure means for reducing the charged particle beam patterned through the mask and for exposing the same on a semiconductor device to be exposed.

The transparent mask may have formed thereon small partitions required for pattern exposure of the same integrated circuit, and the pattern exposure required for fabrication of said integrated circuit is performed without changing said transparent mask.

According to the present invention, the small partitions are arranged within the aggregate partition in accordance with exposure sequence, and likewise the aggregate partitions are also arranged in accordance with exposure sequence. For this reason, the time needed for mechanical mask movement to select and expose a requested small partition and the time needed for charged beam deflection can be minimized without depending upon the number of small partitions. Consequently, the time needed to expose all of requested patterns on a subject to be exposed can be greatly saved, as compared with the prior art.

### BRIEF DESCRIPTION OF THE DRAWINGS

The features and advantages of a fabrication method of semiconductor devices and a transparent mask for a charged particle beam according to the present invention will be more clearly understood from the following description taken in conjunction with the accompanying drawings:
FIG. 1A is a schematic view of a charged particle beam exposure apparatus which serves to explain the basic concept of the present invention;
FIG. 1B is an enlarged plan view of the transparent mask of FIG. 1A;
FIG. 1C is a fragmentary plan view, on a greatly enlarged scale, of various patterns formed on the small partition of the mask of FIG. 1B;
FIG. 2A is a perspective view illustrating an electron beam exposure apparatus for carrying out the fabrication method of semiconductor devices according to the present invention;
FIG. 2B is a cross sectional view of the transparent mask of FIG. 2A;
FIG. 2C is a plan view of the central portion of the transparent mask of FIG. 2B;
FIG. 2D is an enlarged plan view showing the layout of the small partitions within one aggregate partition of a plurality of aggregate partitions on the transparent mask of FIG. 2C;
FIG. 3A is a cross sectional view illustrating schematically an example of the structure of a transparent mask;
FIG. 3B is a bottom plan view of the transparent mask of FIG. 3A;
FIG. 4A is a schematic plan view of a mechanical movement mechanism for positioning the mask to an electron beam illumination position;
FIG. 4B is a block diagram illustrating the interrelationship between the major process steps used to mechanically move the mask to the electron beam illumination position;
FIG. 5A is a plan view illustrating schematically an IC memory chip consisting of memory cell parts and a marginal circuit part;
FIG. 5B is an enlarged plan view representing small partitions selected from patterns of the memory cell parts and the marginal circuit part with respect to a wiring layer pattern among the underlying layer patterns comprising the IC memory of the FIG. 5A; and
FIG. 5C is an enlarged plan view illustrating schematically the layout of patterns on one aggregate partition on the mask, in accordance with which the wiring layer pattern as shown in FIG. 5B is obtained.

### DESCRIPTION OF THE PREFERRED EMBODIMENTS

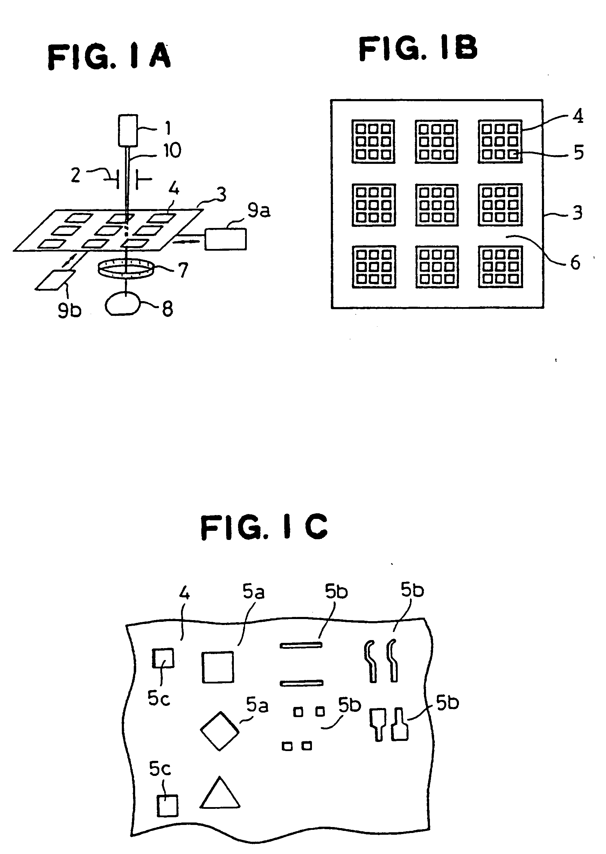

The basis concept of the present invention is shown in Figs. 1A, 1B and 1C of the accompanying drawings. In Fig. 1A, a beam of charged particles 10 is injected from a charged-particle-beam generation means 1, deflected by deflection means 2 for electromagnetically deflecting a charged particle beam, and projected on a transparent mask 3. The transparent mask 3 is mechanically moved by mechanical drive means 9a and 9b. As shown in Fig. 1B, on the transparent mask 3 are formed a plurality of aggregate partitions 4, each of which is subdivided into a plurality of small partitions 5. Each small partition 5 is an area which the charged particle beam 10 can illuminate at a time, while each aggregate partition 4 is a range in which the charged particle beam 10 can be scanned by the aid of the deflection means 2. As shown in Fig. 1C, a small partition group contains repeated basic patterns 5b each representing at least a portion of a figure which is a repeat unit of repeated patterns, and aperture patterns 5a for compositing a non-repeated portion by the same variable rectangular patterns as the prior art. If necessary, the small partition group may further contain registration patterns 5c. The registration patterns 5c are provided in predetermined locations of each aggregate partition 4 and used for registration of the small partition 5. The repeated basic patterns 5b are convenient to constitute particular repeated patterns of a semiconductor device to be fabricated, and selected so that a charged particle beam of small aberration can be obtained. For example, one cell to several cells of DRAM (dynamic random-access memory) or one cell to at least a portion of several cells of SRAM (static random-access memory) can be made an object of the repeated basic patterns 5b. The repeated basic patterns 5b are constructed such that repeated patterns can be printed by connecting one repeated basic pattern itself in head-to-tail manner or connecting the combination of some of them in head-to-tail manner. For example, as shown on the right side of Fig. 1C, when a circuit figure is composited by rectangular patterns, there are patterns including plural sets of composite rectangular patterns each composited by plural rectangular patterns, and including plural rectangular patterns disposed in the right side of the composite rectangular patterns. As in the prior art, that portion of a circuit pattern that is not repeated is made by combination of variable rectangular apertures, because if patterns of complicated figure are made, the vast number of patterns different in kind are required. For this reason, the aperture patterns 5a are needed. As a result, it is desired that aperture patterns 5a of rectangle and the like of at least partly common shape be provided in each of many aggregate partitions 4.

The charged particle beam 10 patterned through the transparent mask 3 is reduced and projected on a subject 8 to be exposed, by reduction exposure means 7.

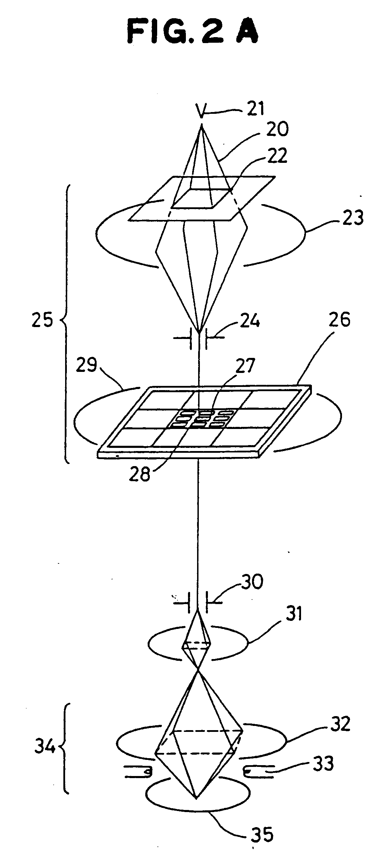

An embodiment of the present invention is shown in Figs. 2A through 2E.

Fig. 2A schematically illustrates an electron beam exposure apparatus. A beam of electrons 20 injected by an electron gun 21 is formed into a rectangular shape with a first formation aperture 22, and focused with a lens 23. The focused electron beam 20 is illuminated by a deflector 24, which is used to select a small partition, on a repeated basic pattern of an arbitrary small partition 28 within one aggregate partition 27 on a transparent mask 26. The electron beam 20 patterned is focused at a deflector 30 by a lens 29. Thereafter, the patterned electron beam 20 is projected on a reduction lens 31 and further deflected and exposed on a wafer 35 by a deflection unit 34 having a lens 32 and a deflector 33. On one aggregate partition 27 of the transparent mask 26 are also formed apertures of variable rectangle (slit having no pattern) that are used for patterns not repeated.

The first formation aperture 22 is used to define the outline of the electron beam 20 so that the beam 20 illuminates only one small partition 28 on the transparent mask 26 and does not illuminate neighboring small partitions 28.

The deflector 24 for selecting a small partition is used to deflect the electron beam 20 within one aggregate partition 27. For example, the deflection of the order of 3 to 5 mm in one direction can be made on the transparent mask 26.

The electron beam 20 patterned by the aperture of one small partition 28 on the transparent mask 26 is once image formed by the lens 29 and reduced, for example, to 1/100 by the reduction lens 32. By reducing, printing patterns are made fine. Accordingly, when finer patterns are printed, it is preferable that the patterns on the mask 26 be exposed with a larger reduction ratio.

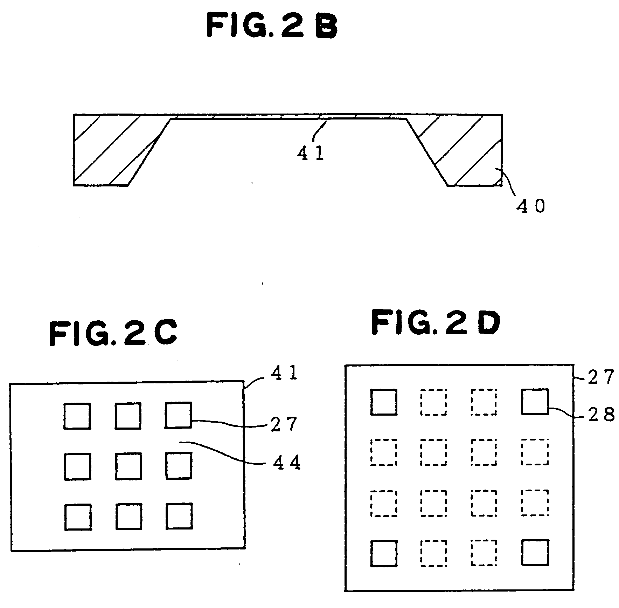

The transparent mask 26 comprises a silicon wafer 40, the central portion 41 of which is in the form of a thin stencil and formed with aperture patterns, as shown in Fig. 2B. Of course, the mask may be made from a metal plate and the like. The central portion 41 of the transparent mask 26 is of a rectangular shape, between 30 and 50 mm on each side, and formed with a plurality of the aggregate partitions 27, as shown in Fig. 2C. The aggregate partition 27 has as a pattern forming region a rectangle of 3 to 5 mm on each side, which is a range in which the electron beam can be deflected without mechanically moving a mask stage. The aggregate partitions 27 are isolated from each other by an isolated region 44.

In each aggregate partition 27 are distributed a plurality of the small partitions 28 in the form of a matrix, as shown in Fig. 2D. Each small partition 28 is of a rectangular shape of 200 to 500 µm on each side. The size of the small partition 28 is determined by the size of an electron beam that can project an image of mask patterns with high fidelity onto the wafer 35 that is a subject to be exposed.

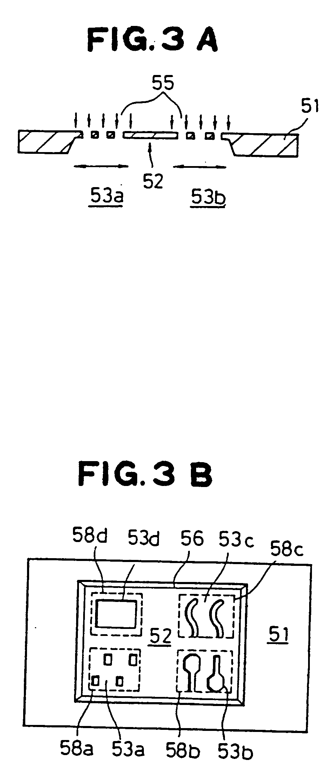

Figs. 3A and 3B schematically illustrate an example of structure of an aggregate partition, respectively.

In Fig. 3A, a Si substrate 51 is formed at its back surface with a generally U-shaped portion 52 by etchings. The central portion 52 are formed with transparent patterns 53a and 53b upon which an electron beam 55 is incident from the upper surface of the substrate 51.

Fig. 3B is a bottom plan view of the transparent mask 51 of Fig. 3A. Between the thin central portion 52 and the thick marginal portion 51 there is a portion 56 that is gradually reduced in thickness. The central portion 52 forms one aggregate partition, which is divided into pattern formable regions 58a, 58b, 58c and 58d which are small partitions. The pattern formable regions 58a, 58b, 58c and 58d are formed with transparent patterns 53a, 53b, 53c and 53d, respectively. The transparent patterns 53a are those which include four rectangles, the transparent patterns 53b those in which two shapes with enlarged ends are disposed in inverse parallel relationship, and the transparent patterns 53c those which includes two meander-shaped parallel paths. These patterns are figures that become a repeat unit of repeated patterns. The transparent pattern 53d is an aperture for a pattern not repeated, and an incident beam is normally formed using two sides of the aperture.

An actual transparent mask includes a plurality of such aggregate partitions, and also it is normally preferable that the number of patterns within the aggregate partition be more many.

In the exposure process, for example, for one chip of a semiconductor device, the repeated basic patterns are exposed in sequence. For example, two elongated lines in the longitudinal direction are exposed by sequentially exposing the patterns 53c of Fig. 3B in the longitudinal direction.

When a new shape is exposed, a suitable aggregate partition is selected corresponding to the shape, and mechanically moved to an electron beam illumination position.

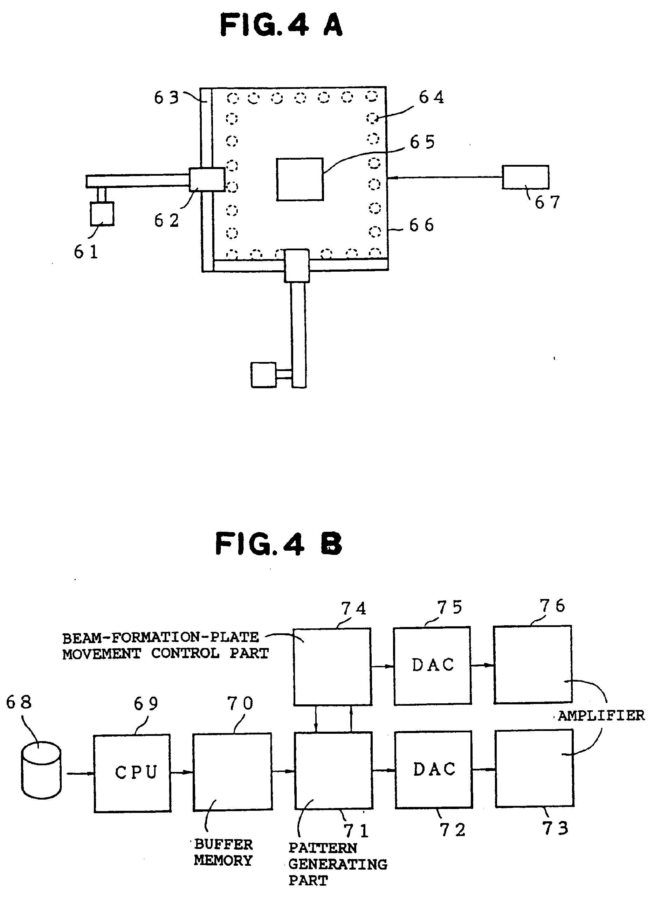

Figs. 4A and 4B show an example of a mechanical movement mechanism.

In Fig. 4A, a drive motor is designated by 61, and a coupling by 62. The coupling 62 is mounted on a guide 63. 64 indicates a ball rotatable in all directions, and 65 a location on which a mask plate with patterns is placed. A mirror 66 is provided to reflect light generated from a laser 67 and measure it. A laser measuring unit (not shown) is also provided in the longitudinal direction to monitor the position of the mask plate and precisely position the mask plate to the electron beam illumination position.

Fig. 4B illustrates the interrelationship between the major process steps used to mechanically move the mask plate to the electron beam illumination position. Exposure data is made by a CPU (central processing unit) 69 in accordance with figure data in a file 68, and once stored in a buffer memory 70. A pattern generating part 71 retrieves the exposure data, a beam-formation-plate movement control part 74 generates a command to move a requested aggregate partition to the electron beam illumination position, and the motor 61 is driven through a DAC (digital to analog converter) 75 and an amplifier 76. After mechanical movement of the requested aggregate partition, the pattern generating part 71 reads the pattern of the exposure date, and controls the electron beam through a DAC 72 and an amplifier 73.

As described above, since repeated basic patterns that are convenient to expose one repeated pattern are aggregated within one partition, the repeated pattern can be exposed for a shorter time. In addition, since a plurality of partitions are formed on one transparent mask, various repeated patterns can be printed.

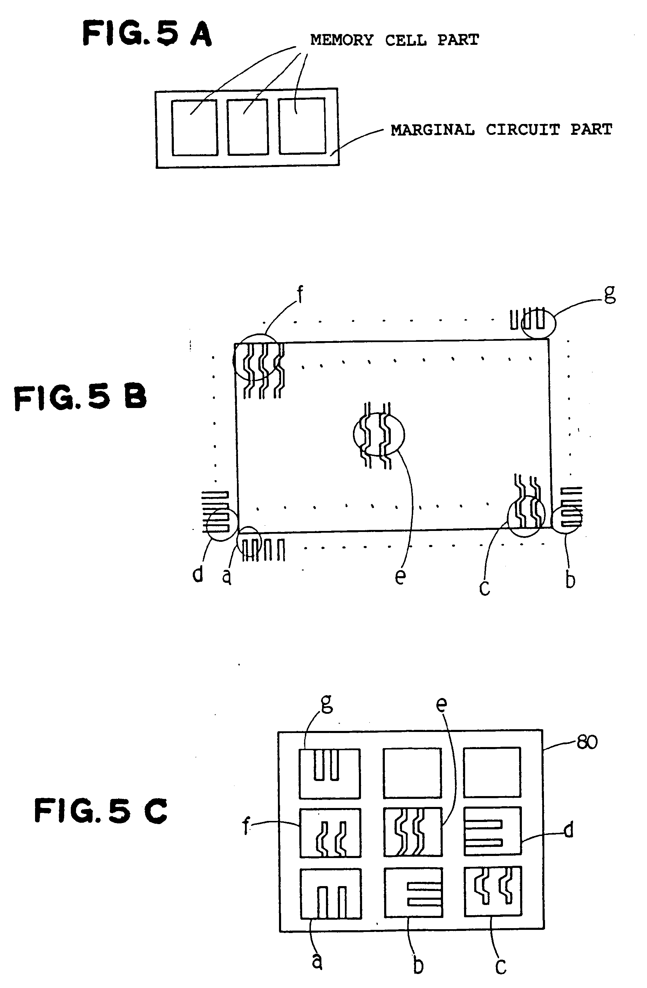

Fig. 5A schematically illustrates an IC memory chip consisting of memory cell parts and a marginal circuit part. The patterns of an IC memory and the like are generally formed by piling patterns of several layers to several tens of layers. Small partitions including patterns that correspond to components of a layer pattern are selected from among all the underlying layers comprising the IC memory, and formed on the transparent mask in accordance with exposure sequence. In Fig. 5B, a to g respectively represent small partitions selected from patterns of the memory cell parts and the marginal circuit part with respect to a wiring layer pattern among the underlying layer patterns comprising the IC memory. These small partitions are disposed within one aggregate partition 80 on the transparent mask, for example, in the order as shown in Fig, 5C, and the exposure is done in the order of a ·· b c ·· d (e ·· b e ·· d) f ·· b g. Note that symbols within the parentheses are repeatedly used as occasion demands. The size of the aggregate partition is determined such that any small partition within the aggregate partition 80 can be selected only by charged-beam deflection means without mechanically moving the transparent mask, and in the case that the number of small partitions selected are large and thus cannot be included in one aggregate partition, they are formed in a neighboring aggregate partition. Also, in order to reduce the number of mechanical mask movements, small partitions including identical patterns can also be disposed repeatedly in different aggregate partitions.

After the transparent mask formed as described above has been placed in a predetermined position in the electron beam exposure apparatus shown in Fig. 2, the small partitions are subsequently selected and exposed by the transparent-mask movement means, deflector and the like, and consequently the wiring layer pattern as shown in Fig. 5B can be obtained.

Also, by selecting small partitions in the same method as described above and arranging them on the transparent mask in the same method as described above with respect to layer patterns other than the wiring layer, all of pattern exposures required for IC memory fabrication can be performed with one transparent mask.

Also, by forming on the transparent mask small partitions including non-repeated patterns along with the aforementioned small partitions for repeated patterns, variable rectangular patterns can also be obtained at the same time by using the small partitions for non-repeated patterns in combination with the rectangular pattern 22 on the transparent mask.

As described previously, the embodiment shown in Figs. 5A to 5C is characterized in that the layout between the small partitions within one aggregate partition are determined so that the small partitions which are close in time in accordance with exposure sequence of a subject to be exposed, are close in location. Also in Fig. 1B, the layout between the aggregate partitions can be determined so that the aggregate partitions which are close in time in accordance with exposure sequence of a subject to be exposed, are close in location. For example, in the case of forming patterns of the same layer, a basic repeated portion of the patterns on the same layer of, for example, SRAM and the like is divided into more than two patterns, which are disposed in neighboring small partitions of one aggregate partition on the mask. On the other hand, in the case of forming patterns of different layers, they are formed on neighboring aggregate partitions on the mask.

Because in accordance with the present invention the distance of movement and number of movements of the transparent mask, and the distance of deflection of the charged beam are minimized, the time required for exposure can be saved as compared with the prior art, thereby enhancing the throughput of the charged beam exposure apparatus.

The invention has been described in detail with particular reference to preferred embodiments thereof but it will be understood that variations and modifications can be effected within the scope of the claims.

## Claims

1. A method for fabricating a semiconductor device, comprising the steps of
generating a charged particle beam (20);
deflecting said charged particle beam (20) electromagnetically and illuminating one small partition (28) of a plurality of small transparent partitions (28) that constitute one aggregate partition (27) of a plurality of aggregate partitions (27) formed on a transparent mask (26);
reducing the charged particle beam patterned through said mask (26) and exposing the same on a semiconductor device (35) to be exposed,
said method having fuerther the steps of
moving one aggregate partition (27) of said plurality of aggregate partitions (27) into a predetermined position by moving said transparent mask (26) mechanically; and
selecting one small partition (28) from among said plurality of small transparent partitions (28) of
said moved aggregate partition (27).

2. A method according to claim 1, further comprising the steps of
forming each aggregate partition (27) of said transparent mask (26) to a size such that said charged particle beam (20) can be deflected on it by deflection means (24);
forming each small partition (28) of said aggregate partitions (27) to a size such that the charged particle beam (20) can be illuminated on said small partition (28) at a time,
forming a pattern group containing repeated basic patterns representing at least a portion of a figure that is a repeat unit to print repeated patterns of said semiconductor device (35) to be exposed, as a small partition group of said small partitions (28) within said each aggregate partition (27);
in accordance with print pattern information of said semiconductor device (35),
selecting one aggregate partition (27) as occasion demands and moving said transparent mask (26) mechanically and also deflecting said charged particle beam (20) electromagnetically; and
selecting said small partitions (28) of said selected aggregate partition (27) sequentially and exposing said repeated patterns of said semiconductor device.

3. A transparent mask for a charged particle beam (20) having patterns for patterning the charged particle beam (20), comprising:
a plurality of aggregate partitions (27), each aggregate partition (27) having a small partition (28) group (2), said small transparent partitions (28) including transparent openings corresponding to components of circuit patterns of an integrated circuit, wherein said small partition (28) group (2) of one aggregate partition (27) contains a first set of small partitions (28), each of which is an aperture pattern that is an independent pattern and used for a nonrepeated pattern repeatedly used for exposure, and a second set of small partitions (28), each of which is a repeated basic pattern representing at least a portion of a figure that is a repeat unit for printing a repeated pattern on a semiconductor chip.

4. A transparent mask according to claim 3, wherein
said first set of patterns is for variable rectangular shape.

5. A transparent mask according to claim 3 or 4, wherein
on said transparent mask (26) neighbouring aggregate partitions (27) are isolated from one another by an isolated region (44);
the size of each of said plurality of aggregate partitions (27) is selected to a size such that said charged particle beam (20) can be deflected with a charged particle beam exposure apparatus; and
the size of each small partition (28) is selected to a size such that said charged particle beam (20) can be illuminated on said small partition (28) at a time.

6. A transparent mask according to claim 3, 4 or 5, wherein
the layout between said aggregate partitions (27) is determined so that said aggregate partitions (27) which are closed in time in accordance with an exposure sequence of a subject (35) to be exposed are close in location, and
the layout between said small partitions (28) within one aggregate partition (27) is determined so that said small partitions (28) which are close in time in accordance with an exposure sequence of a subject to be exposed are close in location.

7. A transparent mask according to anyone of claims 3 - 6, wherein said small partitions (28) formed on said transparent mask (26) are required for pattern exposure of said integrated circuit; and
the pattern exposure required for fabrication of said integrated circuit is perfomed without changing said transparent mask (26).

8. A charged beam exposure apparatus comprising a transparent mask (26) according to anyone of claims 3 - 7, further comprising
means (21 - 23) for generating a charged particle beam (20);
deflection means (24) for deflecting said charged particle beam (20) electromagnetically and illuminating one small partition (28) of said plurality of small partitions (28);
mask movement means (9a, 9b) for moving said transparent mask (26) mechanically; and
reduction-exposure means (30 - 34) for reducing the charged particle beam patterned through said mask (26) and for exposing the same on a semiconductor device (35) to be exposed.

## Patentansprüche

1. Verfahren zur Herstellung einer Halbleitervorrichtung mit den Verfahrensschritten:
Erzeugen eines Ladungsträgerstrahls (20),
elektromagnetisches Ablenken des Ladungsträgerstrahls (20) und Ausleuchten einer kleinen Parzelle (28) aus einer Mehrzahl von kleinen transparenten Parzellen (28), die ein Parzellenaggregat (27) aus einer Mehrzahl von Parzellenaggregaten (27) bilden, die auf einer transparenten Maske (26) ausgebildet sind,
Reduzieren des durch die Maske (26) gemusterten Ladungsträgerstrahls (20) und Aufbelichten desselben auf eine zu belichtende Halbleitervorrichtung (35),
wobei das Verfahren folgende weitere Verfahrensschritte aufweist:
Bewegen eines Parzellenaggregats (27) aus der genannten Mehrzahl von Parzellenaggregaten (27) in eine vorbestimmte Position durch mechanisches Bewegen der transparenten Maske (26) und
Auswählen einer kleinen Parzelle (28) aus der Mehrzahl von kleinen transparenten Parzellen (28) des bewegten Parzellenaggregats (27).

2. Verfahren nach Anspruch 1 mit den weiteren Verfahrensschritten:
Ausbilden jedes Parzellenaggregats (27) der transparenten Maske (26) mit einer solchen Größe, daß der Ladungsträgerstrahl (20) mit Hilfe einer Ablenkvorrichtung (24) darauf abgelenkt werden kann,
Ausbilden jeder kleinen Parzelle (28) des Parzellenaggregats (27) mit einer solchen Größe, daß der Ladungsträgerstrahl (20) diese kleine Parzelle (28) zu einer Zeit ganz ausleuchten kann,
Ausbilden einer Mustergruppe, die wiederholte Grundmuster enthält, die zumindest einen Teil einer Figur darstellen, die eine Wiederholungseinheit zum Drucken von wiederholten Muster der zu belichtenden Halbleitervorrichtung (35) ist, als Gruppe von kleinen Parzellen (28) innerhalb jedes Parzellenaggregats (27),
Auswählen eines Parzellenaggregats (27) in Abhängigkeit von der Druckmusterinformation der Halbleitervorrichtung (35) und mechanisches Bewegen der transparente Maske (26) sowie elektromagnetisches Ablenken des Ladungsträgerstrahls (20), und
sequentielles Auswählen der kleinen Parzellen (28) des ausgewählten Parzellenaggregats (27) und Belichten der wiederholten Muster der Halbleitervorrichtung.

3. Transparente Maske für einen Ladungsträgerstrahl (20), die Muster für das Mustern des Ladungsträgerstrahls (20) aufweist,
mit einer Mehrzahl von Parzellenaggregaten (27), die jeweils eine Gruppe (2) von kleinen transparenten Parzellen (28) aufweisen, die transparente Öffnungen enthalten, die Komponenten von Schaltungsmustern einer integrierten Schaltung entsprechen, wobei die Gruppe (29 von kleinen Parzellen (28) eines Parzellenaggregats (27) einen ersten Satz von kleinen Parzellen (28) enthält, von denen jede ein Öffnungsmuster darstellt, das ein unabhängiges Muster ist und für ein nicht wiederholtes Muster verwendet wird, das wiederholt für die Belichtung verwendet wird, sowie einen zweiten Satz von kleinen Parzellen (28), von denen jede ein wiederholtes Grundmuster ist, das zumindest einen Teil einer Figur darstellt, die eine Wiederholungseinheit zum Drucken eines wiederholten Musters auf einem Halbleiterchip ist.

4. Transparente Maske nach Anspruch 3, bei der der erste Satz von Mustern für eine variable rechteckige Form bestimmt ist.

5. Transparente Maske nach Anspruch 3 oder 4, bei der
benachbarte Parzellenaggregate (27) auf der transparenten Maske (26) durch eine isolierte Region (44) voneinander getrennt sind,
die Größe jedes Parzellenaggregats (27) der Mehrzahl von Parzellenaggregaten so gewählt ist, daß der Ladungsträgerstrahl (20) mit einer Ladungsträgerstrahl-Belichtungsvorrichtung abgelenkt werden kann,
die Größe jeder kleinen Parzelle (28) so gewählt ist, daß der Ladungsträgerstrahl (20) diese kleine Parzelle (28) zu einer Zeit ganz ausleuchten kann.

6. Transparente Maske nach Anspruch 3, 4 oder 5, bei der
das Layout zwischen den Parzellenaggregaten (27) so festgelegt ist, daß diejenigen Parzellenaggregate (27) räumlich benachbart sind, die in einer Belichtungsfolge für ein zu belichtendes Objekt (35) zeitlich benachbart sind, und
das Layout zwischen den kleinen Parzellen (28) innerhalb eines Parzellenaggregats (27) so festgelegt ist, daß diejenigen kleinen Parzellen (28) räumlich benachbart sind, die in einer Belichtungsfolge eines zu belichtenden Objekts (35) zeitlich benachbart sind.

7. Transparente Maske nach einem der Ansprüche 3 bis 6, bei der
die auf der transparenten Maske (26) ausgebildeten kleinen Parzellen (28) die zur Musterbelichtung der integrierten Schaltung benötigten Parzellen sind und
die für die Herstellung der integrierten Schaltung erforderliche Musterbelichtung ohne Austausch der transparenten Maske (26) durchgeführt wird.

8. Ladungsträgerstrahl-Belichtungsvorrichtung mit einer transparenten Maske (26) nach einem der Ansprüche 3 bis 7, die ferner folgende Teile aufweist:
Mittel (21 bis 23) zur Erzeugung eines Ladungsträgerstrahls (20),
Ablenkmittel (24) zum elektromagnetischen Ablenken des Ladungsträgerstrahls (20) und zum Beleuchten einer kleinen Parzelle (28) aus der Mehrzahl von kleinen Parzellen (28),
Maskenbewegungsmittel (9a, 9b) zum mechanischen Bewegen der transparenten Maske (26) und
Belichtungsreduzierungsmittel (30 bis 34) zum Reduzieren des durch die Maske (26) gemusterten Ladungsträgerstrahls und zum Aufbelichten desselben auf eine zu belichtende Halbleitervorrichtung (35).

## Revendications

1. Procédé pour fabriquer un dispositif à semiconducteur, comprenant les étapes :
de production d'un faisceau de particules chargées (20) ;
de déviation du faisceau de particules chargées (20) de façon électromagnétique et d'éclairement d'une petite partition (28) prise parmi plusieurs petites partitions (28) transparentes qui constituent l'un de plusieurs groupements de partitions (27) formés sur un masque transparent (26) ;
de réduction du faisceau de particules chargées, conformé suivant un motif par passage à travers le masque (26), et de projection de celui-ci sur un dispositif à semi-conducteur (35) qui doit être exposé ;
ledit procédé comprenant en outre les étapes :
de déplacement de l'un des groupements de partitions (27) pour l'amener dans une position prédéterminée en déplaçant mécaniquement ledit masque transparent (26) ; et
de sélection de l'une des petites partitions transparentes (28) dudit groupement de partitions (27) déplacé.

2. Procédé selon la revendication 1, comprenant en outre les étapes :
de formation de chaque groupement de partitions (27) dudit masque transparent (26) à une taille telle que ledit faisceau de particules chargées (20) puisse être dévié sur celui-ci par le moyen de déviation (24) ;
de formation de chaque petite partition (28) desdits groupements de partitions (27) à une taille telle que le faisceau de particules chargées (20) puisse éclairer toute ladite petite partition (28) à la fois ;
de formation d'un groupe de motifs contenant des motifs de base répétés représentant au moins une partie d'un tracé qui est une unité de répétition pour imprimer des motifs répétés dudit dispositif à semi-conducteur (35) à exposer, sous forme d'un groupe desdites petites partitions (28) à l'intérieur de chacun desdits groupements de partitions (27) ;
en fonction de l'information de motif imprimé dudit dispositif à semi-conducteur (35), de sélection d'un groupement de partitions (27) en fonction des besoins et de déplacement dudit masque transparent (26) mécaniquement et également de déviation dudit faisceau de particules chargées (20) de façon électromagnétique ; et
de sélection, de façon séquentielle, desdites petites partitions (28) dudit groupement de partitions (27) sélectionné, et d'exposition desdits motifs répétés dudit dispositif à semi-conducteur.

3. Masque transparent pour un faisceau de particules chargées (20), comportant des motifs pour conformer suivant un motif le faisceau de particules chargées (20), comprenant :
plusieurs groupements de partitions (27), chaque groupement de partitions (27) comportant un groupe (2) de petites partitions (28), lesdites petites partitions transparentes (28) incluant des ouvertures transparentes correspondant à des composants de motifs de circuit d'un circuit intégré ; dans lequel ledit groupe (2) de petites partitions (28) d'un groupement de partitions (27) contient un premier ensemble de petites partitions (28), dont chacune est un motif d'ouverture, qui est un motif indépendant et utilisé pour un motif non répété utilisé de manière répétée pour l'exposition, et un second ensemble de petites partitions (28), dont chacune est un motif de base répété représentant au moins une partie d'un tracé qui est une unité de répétition pour imprimer un motif répété sur une puce à semi-conducteur.

4. Masque transparent selon la revendication 3, dans lequel :
ledit premier ensemble de motif sert pour une forme rectangulaire variable.

5. Masque transparent selon la revendication 3 ou 4, dans lequel :
sur ledit masque transparent (26) des groupements de partitions (27) voisins sont séparés l'un de l'autre par une région isolante (44) ;
dans lequel la taille de chacun desdits groupements de partitions (27) est choisie pour être une taille telle que ledit faisceau de particules chargées (20) puisse être dévié à l'aide d'un appareil d'exposition par faisceau de particules chargées ; et
dans lequel la taille de chaque petite partition (28) est choisie pour être une taille telle que ledit faisceau de particules chargées (20) puisse éclairer toute ladite petite partition (28) à la fois.

6. Masque transparent selon la revendication 3, 4 ou 5, dans lequel :
l'implantation desdits groupements de partitions (27) est déterminée de telle façon que lesdits groupements de partitions (27) qui sont proches temporellement dans une séquence d'exposition d'un objet (35) à exposer se trouvent à des emplacements proches ; et
dans lequel l'implantation desdites petites partitions (28), à l'intérieur d'un groupement de partitions (27), est déterminée de telle façon que lesdites petites partitions (28) qui sont proches temporellement dans une séquence d'exposition d'un objet à exposer se trouvent à des emplacements proches.

7. Masque transparent selon l'une quelconque des revendications 3 à 6 dans lequel :
lesdites petites partitions (28) formées sur ledit masque transparent (26) sont nécessaires pour une exposition de motif dudit circuit intégré ; et
dans lequel l'exposition de motif requise pour la fabrication dudit circuit intégré s'effectue sans changer ledit masque transparent (26).

8. Appareil d'exposition par faisceau chargé, comprenant un masque transparent (26) selon l'une quelconque des revendications 3 à 7, comprenant en outre :
des moyens (21 à 23) pour produire un faisceau de particules chargées (20) ;
des moyens de déviation (24) pour dévier ledit faisceau de particules chargées (20) de façon électromagnétique et pour éclairer l'une desdites petites partitions (28) ;
un moyen de déplacement de masque (9a, 9b) pour déplacer mécaniquement ledit masque transparent (26) ; et
un moyen d'exposition avec réduction (30 à 34) pour réduire le faisceau de particules chargées, conformé suivant un motif par passage à travers ledit masque (26), et pour le projeter sur un dispositif à semi-conducteur (35) qui doit être exposé.
